# FASCICULE DE BREVET EUROPEEN

(11) **EP 2 537 796 B1**
(45) Date de publication et mention de la délivrance du brevet: **19.06.2019**
(21) Numéro de dépôt: 12172712.7
(22) Date de dépôt: 20.06.2012
(51) Int. Cl.: B81B 7/00

(54) **Structure getter comportant un matériau perméable aux gaz**
Getter-Struktur, die ein gasdurchlässiges Material umfasst
Getter structure comprising a gas-permeable material

(30) Priorité: 23.06.2011 FR 1155565
(43) Date de publication de la demande: 26.12.2012
(73) Titulaire: Commissariat à l'Énergie Atomique et aux Énergies Alternatives, 75015 Paris (FR)
(72) Inventeur: Caplet, Stéphane, Tapei City Taiwan 111 (CN)
(74) Mandataire: Ilgart, Jean-Christophe

(56) Documents cités:
- WO-A1-2008/071906
- WO-A1-2009/041950
- CAPLET S ET AL: "Vacuum wafer-level packaging for MEMS applications", PROCEEDINGS OF SPIE, SPIE, US, vol. 4979, 27 janvier 2003 (2003-01-27), pages 271-278, XP002360340, ISSN: 0277-786X, DOI: 10.1117/12.478249

## Description

### DOMAINE TECHNIQUE

L'invention concerne le domaine des structures getter, c'est-à-dire des structures comprenant un ou plusieurs matériaux getter pour réaliser une absorption et/ou une adsorption gazeuse. Une telle structure peut notamment être utilisée dans le domaine des microcomposants tels que les microsystèmes électromécaniques (MEMS) ou nanosystèmes électromécaniques (NEMS), par exemple des accéléromètres, des gyromètres, ou tout autre dispositif par exemple destiné à être encapsulé dans un environnement sous vide poussé, sous pression contrôlée, ou encore sous atmosphère protectrice.

### ÉTAT DE LA TECHNIQUE ANTÉRIEURE

Un matériau getter est un matériau comportant, de façon intrinsèque et/ou de par sa morphologie microscopique, des propriétés d'absorption et/ou d'adsorption gazeuse. Un tel matériau getter peut ainsi former une pompe de gaz chimique lorsque celui-ci est disposé dans un environnement clos. Ce type de matériau peut également être utilisé dans de nombreuses applications microélectroniques telles que les tubes à vide, les systèmes à effet de champ ou encore avec des microcomposants tels que les MEMS ou NEMS pour réaliser par exemple un environnement sous vide poussé ou sous pression contrôlée. Dans le cas des MEMS ou NEMS encapsulés, un environnement sous vide poussé formé autour du dispositif permet par exemple d'obtenir un meilleur fonctionnement des systèmes mécaniques résonnants mais aussi des systèmes optiques sensibles à l'absorption du rayonnement lumineux par des gaz environnants du dispositif.

Des matériaux getter non évaporables (appelés NEG) sont par exemple des métaux tels que du titane, du zirconium, de l'hafnium, ou encore des alliages métalliques binaires de ces trois métaux. Un tel matériau getter non évaporable est généralement déposé directement sur une paroi de l'enceinte dans laquelle on cherche à réaliser une pompe chimique sous la forme d'une couche mince. Ce matériau est ensuite activé thermiquement en le chauffant à travers la paroi de l'enceinte sur laquelle il est déposé. Le document US 6 923 625 B2 décrit la réalisation d'une telle couche mince de matériau getter.

La capacité de pompage d'une telle couche mince de matériau getter est déterminée par la surface du matériau en contact avec le gaz à absorber. Plus cette surface est grande, plus la capacité d'absorption du matériau getter est importante. Dans le document US 6 923 625 B2, il est décrit notamment que la couche mince de matériau getter peut être déposée sur une surface présentant des saillies. Ainsi, la surface du matériau getter déposé sur les parois latérales des saillies permet d'augmenter la surface totale absorbante et/ou adsorbante du matériau getter dans la cavité.

Toutefois, cette augmentation de surface du getter implique de structurer la surface sur laquelle le matériau getter est déposé, ce qui complique la réalisation du dispositif comportant une telle structure getter. De plus, il n'est parfois pas possible de réaliser une telle structuration de la surface destinée à recevoir le matériau getter.

Le document WO 2008/071906 A1 décrit une structure getter comportant une portion de matériau getter 360 dont une face est disposée contre une portion de matériau getter poreux 340 réalisée sur un substrat 320. La portion de matériau getter 360 est destinée à protéger la portion poreuse 340 en s'oxydant plus rapidement que la portion poreuse 340.

Le document WO 2009/041950 A1 décrit une structure getter comportant un support 1040, une première couche de dessicant 1030, une couche de faible perméation 102 et une deuxième couche de dessicant 1010.

Le document CAPLET S. et al. : « Vacuum wafer-level packaging for MEMS applications », Proceedings of SPIE, SPIE, US, vol.4979, 27 janvier 2003, pages 271-278, décrit une structure getter comportant une portion de matériau getter disposée entre un capot de silicium traversé par une ouverture et un capot de verre.

### EXPOSÉ DE L'INVENTION

Un but de la présente invention est de proposer une structure getter augmentant, pour une même portion ou couche de matériau getter, la surface d'absorption et/ou d'adsorption gazeuse du matériau getter sans avoir à réaliser une structuration en relief, par exemple en saillies, de la surface destinée à recevoir le matériau getter.

Pour cela, la présente invention propose une structure getter selon la revendication 1.

La structure getter comportant au moins une portion de matériau getter dont au moins une face est disposée contre au moins une portion de matériau perméable aux gaz telle que ladite portion de matériau getter soit apte à réaliser une absorption et/ou une adsorption gazeuse au moins par ladite face à travers au moins ladite portion de matériau perméable aux gaz, et dans laquelle la portion de matériau perméable aux gaz comporte un ou plusieurs canaux réalisés au niveau d'une face de ladite portion de matériau perméable aux gaz qui est en contact avec la portion de matériau getter, la portion de matériau getter étant apte à réaliser une absorption et/ou une adsorption gazeuse via le ou les canaux.

Il est également proposé une structure getter comportant au moins une portion de matériau getter dont au moins une face est disposée contre au moins une portion de matériau perméable aux gaz telle que ladite portion de matériau getter soit apte à réaliser une absorption et/ou une adsorption gazeuse au moins par ladite face à travers au moins ladite portion de matériau perméable aux gaz.

La structure getter rend accessible la face « cachée », par exemple la face arrière, de la portion de matériau getter, à savoir la face de la portion de matériau getter destinée à se trouver du côté du support sur lequel repose, ou est suspendue, la portion de matériau getter. Par rapport à une structure getter de l'art antérieur où la quasi-totalité de la surface d'absorption et/ou d'adsorption gazeuse est formée par la face avant de la portion de matériau getter, on double quasiment cette surface en rendant la face arrière de la portion de matériau getter accessible aux gaz.

On entend par « perméabilité » d'une portion de matériau son aptitude à permettre la circulation de gaz dans ladite portion de matériau, par exemple aussi bien dans au moins une direction parallèle à un plan principal de la portion que dans une direction perpendiculaires à ce plan. Des gaz peuvent donc circuler à travers la portion de matériau perméable aux gaz, par exemple aussi bien latéralement que verticalement.

Une telle structure getter peut être disposée dans une cavité dans laquelle sont encapsulés un ou plusieurs microcomposants. Ainsi, les faces avant et arrière de la portion de matériau getter, voir même toutes les faces de la portion de matériau getter, peuvent servir à l'absorption et/ou l'adsorption des gaz présents dans la cavité. Une telle structure getter peut également être disposée à l'extérieur de la cavité, par exemple sur un capot fermant la cavité, la portion de matériau perméable au gaz recouvrant une ouverture formée à travers le capot et telle que le matériau getter puisse communiquer avec l'intérieur de la cavité à travers cette ouverture et la portion de matériau perméable aux gaz.

Le terme « portion » peut désigner une ou plusieurs parties d'une couche ou de plusieurs couches, par exemple une ou plusieurs parties restantes d'une ou plusieurs couches gravées, mais également une ou plusieurs couches non gravées, c'est-à-dire une ou plusieurs couches entières.

La portion de matériau perméable aux gaz peut comporter un ou plusieurs canaux réalisés au niveau d'une face de ladite portion de matériau perméable aux gaz qui est en contact avec la portion de matériau getter, la portion de matériau getter étant apte à réaliser une absorption et/ou une adsorption gazeuse via le ou les canaux. Une telle portion de matériau perméable aux gaz peut être réalisée à partir de n'importe quel type de matériau dans lequel il est possible de former ce ou ces canaux, par exemple par gravure. Le ou les canaux de la portion de matériau perméable aux gaz contribuent pour tout ou partie à la perméabilité de ladite portion perméable. Que la portion de matériau perméable au gaz soit composée ou non d'un matériau poreux, le ou les canaux réalisés permettent d'avoir une excellente circulation des gaz au sein de la portion de matériau perméable au gaz.

Une partie de ladite face de la portion de matériau perméable aux gaz peut ne pas être recouverte par la portion de matériau getter. Ainsi, il est possible d'accéder à la portion de matériau getter depuis la face de la portion de matériau perméable aux gaz sur laquelle se trouve la portion de matériau getter, via le matériau perméable aux gaz. De plus, lorsque la portion de matériau perméable aux gaz comporte un ou plusieurs canaux, le ou les canaux peuvent déboucher au niveau de cette partie de la portion de matériau perméable aux gaz non recouverte.

Lorsque le matériau getter comporte une perméabilité locale, soit par un ou plusieurs canaux gravés soit par une porosité intrinsèque au matériau utilisé, ladite partie de matériau perméable peut être complètement recouverte par la portion de matériau getter, les gaz traversant alors le matériau getter par cette perméabilité locale pour ensuite diffuser à l'interface grâce au matériau perméable.

La portion de matériau perméable aux gaz peut être composée d'au moins un matériau poreux. Dans ce cas, les dimensions des pores, ou porosités, de ce matériau poreux influent sur la vitesse de l'accessibilité des gaz au matériau getter. Ces pores sont par exemple ouverts et de dimensions (dimension d'un côté ou d'un diamètre selon la forme des pores) comprises entre environ quelques nanomètres et quelques centaines de nanomètres, par exemple comprises entre environ 2 nm et 900 nm.

Une partie de la portion de matériau perméable aux gaz peut ne pas être recouverte par la portion de matériau getter.

La portion de matériau perméable aux gaz peut être disposée entre la portion de matériau getter et un support.

La portion de matériau perméable aux gaz peut également présenter des propriétés d'adsorption et/ou d'absorption gazeuse. La portion de matériau perméable peut être composée de matériau getter. Ainsi, il est possible d'obtenir une structure getter comprenant au moins deux matériaux getter différents qui peuvent éventuellement avoir des propriétés d'absorption et/ou d'adsorption différentes.

La portion de matériau perméable aux gaz peut entourer tout ou partie de la portion de matériau getter. Ainsi, la portion de matériau getter peut réaliser une absorption et/ou une adsorption gazeuse depuis toutes ses faces qui sont en contact avec le matériau perméable aux gaz.

La structure getter peut comporter en outre au moins une couche de protection hermétique aux gaz recouvrant un empilement comprenant au moins la portion de matériau perméable aux gaz et la portion de matériau getter. Ainsi, il est possible de protéger le matériau getter pendant que la structure getter ou le dispositif dans lequel est utilisée la structure getter subit des étapes pouvant détériorer le matériau getter. De plus, il est possible d'empêcher temporairement le matériau getter, qui peut être activé thermiquement, de réaliser une absorption et/ou une adsorption gazeuse. Le matériau getter peut être rendu accessible après avoir réalisé une ouverture dans la couche de protection. Ainsi, il est possible de réaliser une activation de la fonction d'absorption et/ou d'adsorption gazeuse du matériau getter au moment souhaité, par ouverture contrôlée de la couche de protection.

La structure getter peut comporter en outre au moins une ouverture formée à travers la couche de protection hermétique aux gaz et débouchant sur l'empilement. L'ouverture peut déboucher sur la portion de matériau perméable aux gaz, et/ou sur la portion de matériau getter lorsque le matériau getter présente une perméabilité locale.

La structure getter peut comporter un empilement de plusieurs portions de matériau getter et de plusieurs portions de matériau perméable au gaz, au moins une face de chacune des portions de matériau getter pouvant être disposée contre au moins une des portions de matériau perméable aux gaz telle que chacune des portions de matériau getter puisse être apte à réaliser une absorption et/ou une adsorption gazeuse par ladite face à travers au moins ladite une des portions de matériau perméable aux gaz.

La couche de protection hermétique aux gaz peut recouvrir l'empilement de portions de matériau getter et de portions de matériau perméable au gaz. Au moins une ouverture peut être formée à travers la couche de protection hermétique aux gaz et déboucher sur l'empilement. L'ouverture peut déboucher sur au moins l'une des portions de matériau perméable aux gaz, et/ou sur au moins l'une des portions de matériau getter lorsque le matériau getter présente une perméabilité locale.

L'invention peut concerner également un dispositif comportant au moins un microcomposant encapsulé dans une cavité, et au moins une structure getter telle que décrite précédemment, apte à réaliser une absorption et/ou une adsorption du gaz présent dans la cavité.

L'invention peut concerner également un dispositif comportant au moins un microcomposant encapsulé dans une cavité, et dans lequel au moins une structure getter telle que décrite précédemment est disposée dans la cavité.

La cavité peut être formée entre un substrat et un capot.

La structure getter peut être solidaire du substrat ou du capot.

L'invention peut concerner également un dispositif comportant au moins un microcomposant encapsulé dans une cavité, au moins une ouverture étant formée à travers au moins une paroi de la cavité et recouverte par une partie d'une portion de matériau perméable aux gaz d'une structure getter telle que décrite précédemment. La cavité peut être formée entre un substrat et un capot. Le substrat et le capot peuvent ne pas être homogènes. En particulier, ils peuvent être formés par un substrat avec des parois latérales, le capot et le substrat prenant appui l'un avec l'autre au niveau de ces parois.

Il est également proposé un procédé de réalisation d'une structure getter comportant au moins les étapes de :
- réalisation d'au moins une portion de matériau perméable aux gaz ;
- réalisation d'au moins une portion de matériau getter dont au moins une face est disposée contre la portion de matériau perméable aux gaz telle que ladite portion de matériau getter soit apte à réaliser une absorption et/ou une adsorption gazeuse par ladite face à travers au moins ladite portion de matériau perméable aux gaz.

L'invention concerne en outre un procédé de réalisation d'une structure getter selon la revendication 10.

La portion de matériau perméable aux gaz et/ou la portion de matériau getter et/ou la couche de protection hermétique peuvent être réalisées par des dépôts à travers un ou plusieurs pochoirs.

Les dépôts peuvent être mis en oeuvre sous une même atmosphère, ou dans un même cycle de vide. On entend par « même cycle de vide » le fait que l'on ne remet pas la structure à l'air libre. On peut éventuellement, dans un même cycle de vide, remettre la structure sous atmosphère neutre notamment pour le transfert d'un équipement à un autre, par exemple d'une chambre de dépôt à une autre, afin de d'éviter de saturer le matériau getter déposé.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4B et 10A à 10C représentent des structures getter selon des variantes exemplaires ;
- les figures 5A à 5C représentent les étapes d'un procédé de réalisation d'un dispositif, objet de la présente invention, comportant une structure getter, également objet de la présente invention ;
- les figures 7, 8 et 9A représentent les étapes d'un procédé de réalisation d'un dispositif comportant une structure getter, selon des variantes exemplaires ;

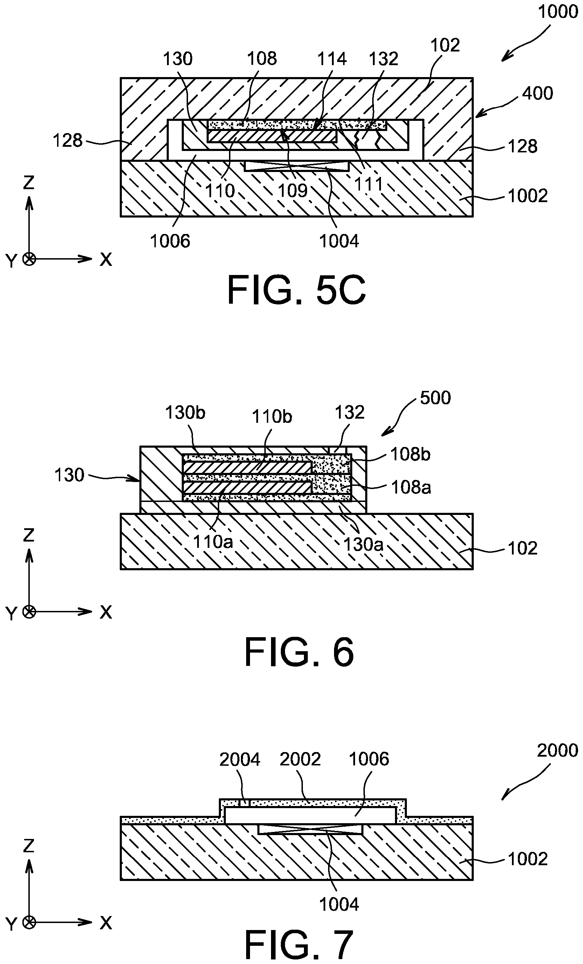

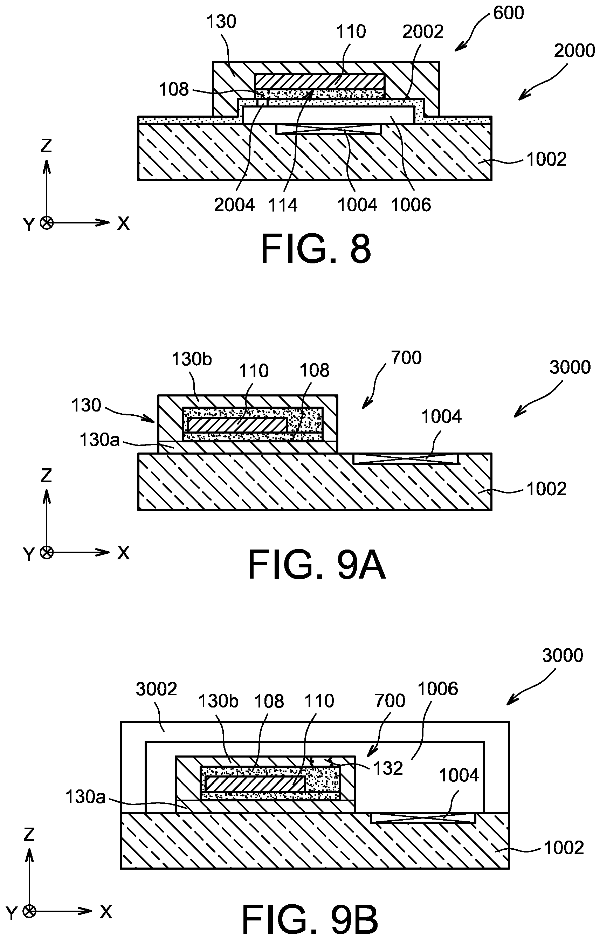

- les figures 6 et 9B représentent des structures getter selon des modes de réalisation de l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

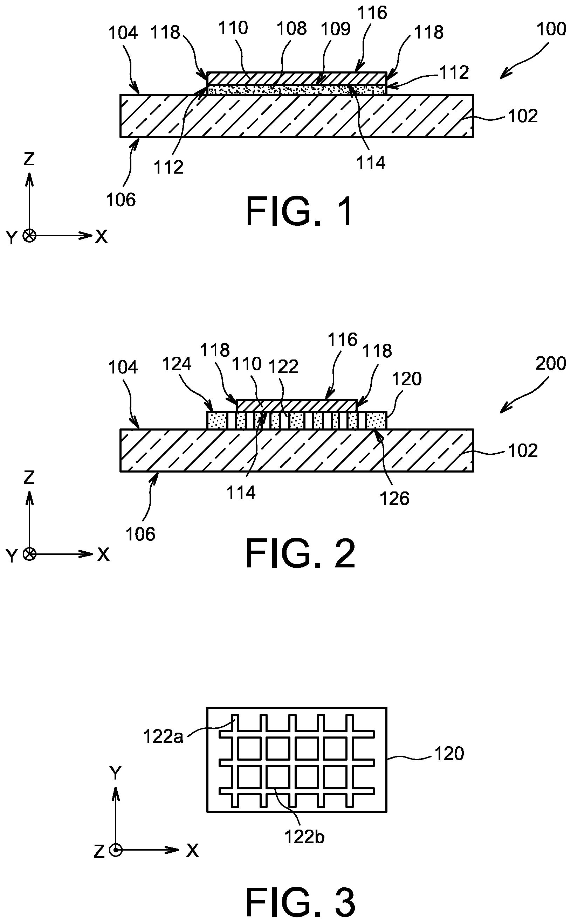

On se réfère tout d'abord à la figure 1 qui représente une structure getter 100 selon un premier mode de réalisation.

La structure getter 100 comporte un support 102, par exemple une couche de semi-conducteur, comprenant deux faces principales 104 et 106. La structure 100 comporte également une portion 108 de matériau perméable aux gaz formée sur l'une des faces principales 104 du support 102. Cette perméabilité aux gaz du matériau de la portion 108 est obtenue ici du fait que le matériau de la portion 108, par exemple du SiOC déposé par pulvérisation cathodique sur le support 102, est de nature poreuse. En variante, une telle portion de matériau poreux 108 peut être formée par un dépôt par évaporation de SiO₂, tel que décrit dans le document « Nanostructured porous SiO2 films for antireflection coatings » de K.M.A Sobahan et al., Optics Communication, Volume 284, Issue 3, Février 2011, pages 873-876, ou par un dépôt métallique de type ZrO₂ par évaporation tel que décrit dans le document « Some approaches to producing microporous materials and coatings by EB PVD » de B.A. Movchan et al., Surface and Coatings Technology, Volume 165, Issue 1, 3 février 2003, pages 90-100.

Les porosités ouvertes du matériau poreux permettent aux gaz de circuler à travers la portion de matériau perméable aux gaz. Les porosités peuvent être à la fois latérales (porosités présentant des ouvertures au niveau de ses faces latérales) et verticales (présentant des ouvertures au niveau de ses faces avant et arrière), ces différentes porosités communiquant entre elles au sein de la portion 108.

Dans l'exemple décrit ici, la portion de matériau poreux 108 est par exemple obtenue en réalisant tout d'abord un dépôt par pulvérisation cathodique de SiOC sur la face 104 du support 102, puis une structuration, par exemple une gravure, de cette couche afin de ne conserver que la portion 108 dont les dimensions correspondent aux dimensions souhaitées. En variante, la portion de matériau poreux 108 peut être réalisée en une seule étape en déposant le matériau poreux sur la face 104 du support 102 à travers un pochoir, formant ainsi directement la portion de matériau poreux 108 sur la face 104 du support 102.

La structure getter 100 comporte également une portion de matériau getter 110 disposée sur une face 109 de la portion de matériau poreux 108. Comme pour la portion de matériau poreux 108, le matériau getter peut être tout d'abord déposé sous la forme d'une couche, par exemple par évaporation ou par pulvérisation, sur la portion de matériau poreux 108 et sur le support 102, puis structurée (par exemple par gravure) afin de former la portion 110 dont les dimensions sont par exemple similaires à celles de la portion de matériau poreux 108, ou bien être réalisée directement par un dépôt du matériau getter à travers un pochoir. Dans ce premier mode de réalisation, la portion de matériau poreux 108 est complètement recouverte par la portion de matériau getter 110.

Dans un mode de réalisation avantageux, les portions de matériau poreux 108 et getter 110 peuvent être réalisées toutes les deux par deux dépôts successifs à travers un même pochoir, éventuellement au cours d'un même cycle de vide, c'est-à-dire sans remise à l'air entre ces deux dépôts.

Le matériau de la portion 108 comporte des porosités, ou pores, ouvertes telles que du gaz puisse circuler à travers celles-ci. La portion de matériau poreux 108 est donc perméable aux gaz et présente, en son sein, des porosités à la fois horizontales (porosités présentant des ouvertures au niveau de ses faces latérales 112) et verticales (présentant des ouvertures au niveau de sa face 109 en contact avec le matériau getter et au niveau de sa face en contact avec le support 102), ces différentes porosités communiquant entre elles au sein de la portion 108. Ainsi, du gaz peut circuler à travers les porosités de la portion 108 en entrant par les faces latérales 112 de la portion 108 et peut atteindre une face arrière 114 de la portion de matériau getter 110.

La portion de matériau getter 110 peut donc réaliser une absorption et/ou une adsorption gazeuse par sa face avant 116, par ses faces latérales 118, mais également par sa face arrière 114 à travers la portion de matériau poreux 108. Dans ce premier mode de réalisation, la portion de matériau getter 110 peut donc réaliser une absorption et/ou une adsorption gazeuse depuis toutes ses surfaces extérieures (face avant 116, face arrière 114 et faces latérales 118).

La portion de matériau poreux 108 a par exemple une épaisseur comprise entre environ 100 nm et 10 µm. Le matériau getter de la portion 110 est un matériau getter non évaporable, par exemple du titane et/ou du zirconium et/ou du chrome et/ou du vanadium et/ou du niobium et/ou du tantale et/ou tout autre alliage ou matériau présentant des propriétés d'absorption et/ou adsorption gazeuse. La portion de matériau getter 110 a une épaisseur par exemple comprise entre environ 100 nm et 10 µm. La portion de matériau getter 110 pourra être réalisée sous la forme d'une couche mince.

Dans une variante de la structure 100, la portion de matériau poreux 108 et/ou la portion de matériau getter 110 pourraient être réalisées sous la forme de couches non structurées, c'est-à-dire de couches recouvrant la totalité ou une grande partie de la face 104 du support 102.

La figure 2 représente une structure getter 200 selon un deuxième mode de réalisation.

Comme la structure getter 100 précédemment décrite, la structure getter 200 comporte le support 102, ainsi que la portion de matériau getter 110 qui est disposée sur la face 104 du support 102 par l'intermédiaire d'une portion 120 de matériau perméable aux gaz. Toutefois, contrairement à la portion de matériau poreux 108 de la structure getter 100, la perméabilité aux gaz de la portion 120 n'est pas obtenue grâce à la porosité intrinsèque du matériau utilisé (la portion 120 est par exemple à base de SiO₂), mais est obtenue grâce à une structuration d'un réseau dense de canaux 122 réalisés dans la portion de matériau 120. Ces canaux 122, obtenus par exemple par la mise en oeuvre d'étapes de photolithographie et de gravure, traversent ici la portion 120 sur toute son épaisseur (cette épaisseur étant par exemple comprise entre environ 1 µm et 10 µm), depuis une face avant 124 jusqu'à une face arrière 126 de la portion 120.

La figure 3 représente une vue de dessus schématique de la portion de matériau 120 et d'une partie des canaux 122. On voit sur cette figure que la fonction de perméabilité est obtenue grâce à des canaux 122 disposés sous la forme d'un quadrillage composé de canaux verticaux 122a (sensiblement parallèles à l'axe Y) et de canaux horizontaux 122b (sensiblement parallèles à l'axe X), perpendiculaires les uns par rapport aux autres. On voit sur la figure 2 que les dimensions dans le plan (X,Y) de la portion de matériau 120 sont supérieures à celles de la portion de matériau getter 110 afin qu'au moins une partie des canaux 122, ici les extrémités, ne soit pas recouverte par la couche de matériau getter 110. Ainsi, un gaz peut entrer, depuis la face avant 124 de la portion 120, par les extrémités des canaux 122 non recouvertes par la portion de matériau getter 110 et atteindre ensuite la face arrière 114 de la portion de matériau getter 110 en circulant à travers les canaux 122 de la portion de matériau 120. La largeur des canaux (dimension selon l'axe X pour les canaux verticaux 122a et dimension selon l'axe Y pour les canaux horizontaux 122b) est par exemple comprise entre environ 100 nm et 1 µm. Les canaux 122 peuvent être réalisés dans une partie seulement de l'épaisseur de la portion de matériau 120, par exemple dans une épaisseur comprise entre environ 2 et 3 µm. Les canaux 122 sont réalisés de préférence tels qu'ils présentent un rapport de forme (hauteur/largeur) supérieur ou égal à 2. Sur l'exemple de la figure 3, les canaux 122 ne débouchent pas au niveau des faces latérales de la portion de matériau 120. Toutefois, dans une variante, il est possible que les canaux 122 soient débouchant latéralement, les canaux étant dans ce cas accessibles depuis les faces latérales de la portion de matériau 120.

Le motif formé par les canaux 122 peut être différent de celui représenté sur la figure 3, et peut ne pas former un quadrillage. Ainsi, les canaux 122 peuvent former par exemple une étoile, ou n'importe quel motif dans lequel, lorsque la portion de matériau 120 est recouverte par la portion de matériau getter 110, au moins une partie, par exemple les extrémités, du motif formé par ces canaux 122 n'est pas recouverte par la portion de matériau getter 110. Dans une autre variante, il est possible que les canaux 122 débouchent au niveau d'une ou plusieurs des faces latérales de la portion 120 (faces perpendiculaires aux faces en contact avec le support 102 et avec la portion de matériau getter 110). Dans ce cas, la portion de matériau 120 peut être de dimensions similaires à la portion de matériau getter 110 et comporter sa face avant 124 entièrement recouverte par la portion de matériau getter 110.

Dans une variante de réalisation des structures getter 100 et 200 précédemment décrites, il est possible que la portion de matériau poreux 108 ou la portion de matériau 120 comportant les canaux 122 ne soit pas réalisée directement sur le support 102, mais qu'une ou plusieurs portions (ou couches) de matériau(x) soient disposées entre la portion de matériau perméable aux gaz 108 ou 120 et le support 102. Il est également possible qu'une ouverture soit réalisée à travers le support 102 afin d'accéder à la portion de matériau perméable aux gaz 108 ou 120, et ainsi accéder également à la portion de matériau getter 110.

De plus, dans une autre variante de réalisation, il est possible de réaliser les structures getter 100 et/ou 200 précédemment décrites telles que la perméabilité des portions de matériau 108 et/ou 120 soit réalisée par des canaux formés dans lesdites portions, ainsi qu'éventuellement par des porosités intrinsèques au(x) matériau(x) utilisé(s) pour réaliser les portions 108 et/ou 120.

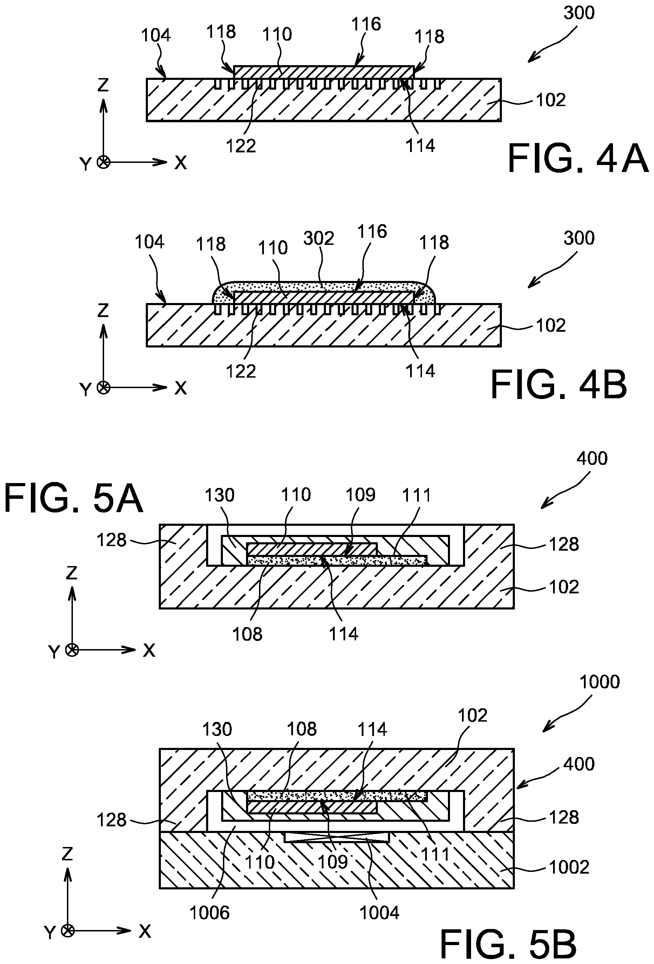

La figure 4A représente une structure getter 300 selon un troisième mode de réalisation.

La structure getter 300 comporte la portion de matériau getter 110 qui est ici disposée directement sur la face avant 104 du support 102, c'est-à-dire contre cette face 104. Ici, les canaux 122 sont réalisés dans le support 102, au niveau de sa face avant 104. Dans ce troisième mode de réalisation, les canaux 122 ne sont réalisés que dans une partie de l'épaisseur du support 102. La partie du support 102 comportant les canaux 122 forme donc une portion de matériau perméable aux gaz.

La fonction de perméabilité aux gaz réalisée par les canaux 122 de cette structure getter 300 est similaire à celle réalisée par les canaux 122 de la structure getter 200 précédemment décrite. Une partie des canaux 122 n'est pas recouverte par la portion de matériau getter 110. Le motif (par exemple en quadrillage) et/ou les dimensions des canaux 122 de la structure getter 200 peuvent être similaires au motif et/ou aux dimensions des canaux 122 de la structure getter 300.

Ainsi, lorsque le substrat 102 peut être gravé, une telle structure getter 300 a pour avantage de ne pas réaliser une portion de matériau supplémentaire entre le substrat et le matériau getter, du fait que les canaux sont réalisés directement dans le substrat.

Les structures getter 200 et 300 précédemment décrites permettent donc au matériau getter 110 de réaliser une absorption et/ou une adsorption gazeuse par sa face arrière 114 sans avoir à mettre en contact cette face arrière 114 avec un matériau comportant intrinsèquement des porosités.

Toutefois, il est possible que le support 102 de la structure getter 300 ou la portion de matériau 120 de la structure getter 200 soit à base d'un matériau poreux, par exemple de nature similaire au matériau poreux de la portion 108 de la structure getter 100.

La figure 4B représente une variante de réalisation de la structure getter 300. Outre les éléments précédemment décrits en liaison avec la figure 4A, la structure getter 300 représentée sur la figure 4B comporte une couche de protection 302 composée d'au moins un matériau fusible (par exemple un métal) recouvrant la portion de matériau getter 110 ainsi que les parties des canaux 122 qui ne sont pas recouvertes par la portion de matériau getter 110.

Ainsi, tant que la portion de matériau getter 110 est recouverte par la couche de protection 302, ce matériau getter est protégé vis-à-vis de l'environnement extérieur. Par contre, lorsque l'on expose la structure getter 300 à une température supérieure à la température de fusion du matériau de la couche de protection 302, le matériau en fusion vient alors se positionner au-dessus de la portion de matériau getter 100 en raison de la forte mouillabilité du matériau fusible vis-à-vis du matériau getter (qui sont par exemple tous les deux des matériaux métalliques), libérant ainsi les parties des canaux 122 (par exemple les extrémités) qui ne sont pas recouvertes par la portion de matériau getter 110.

La couche de protection 302 est avantageusement déposée au cours d'un même cycle de vide que la portion de matériau getter 110, par exemple par évaporation, évitant ainsi toute exposition du matériau getter à l'air libre. La couche de protection 302 est par exemple composée d'indium, et/ou d'un alliage de type or-étain(29% at.), ou encore tout métal ou alliage dont le point de fusion est supérieur aux températures mises en oeuvre lors de l'assemblage de la structure getter 300 avec une structure pour former une cavité dans laquelle est encapsulée la structure getter 300. Ainsi, il est possible de réaliser une « ouverture » des canaux 122 (en raison du retrait du matériau de la couche de protection 302 au-dessus des canaux) et une activation du matériau getter après un tel assemblage.

Il est parfois nécessaire ou avantageux de protéger le matériau getter en l'encapsulant par une couche de protection qui est hermétique aux gaz afin de ne pas exposer temporairement le matériau getter aux gaz environnants. Une telle protection peut notamment être réalisée lorsque la structure getter est disposée au sein d'une cavité dans laquelle sont encapsulés un ou plusieurs microcomposants.

La figure 5A représente une structure getter 400 selon un quatrième mode de réalisation comportant, comme la structure getter 100 précédemment décrite, le support 102 sur lequel sont disposées la portion de matériau poreux 108 et la portion de matériau getter 110. Dans ce quatrième mode de réalisation, le support 102 est destiné à former le capot d'une cavité dans laquelle un microcomposant d'un dispositif 1000 est destiné à être encapsulé. Le support 102 comporte des portions latérales 128 destinées à former des parois latérales de la cavité.

Les dimensions (dans le plan (X,Y)) de la portion de matériau poreux 108 sont ici supérieures à celles de la portion de matériau getter 110 afin qu'une partie 111 de la portion de matériau poreux 108 ne soit pas recouverte par la portion de matériau getter 110.

La structure getter 400 comporte également une couche de protection hermétique 130, par exemple à base d'or et/ou d'aluminium, et dont l'épaisseur est par exemple comprise entre environ 1 µm et 10 µm, encapsulant la portion de matériau getter 110 ainsi que la portion de matériau poreux 108, et protégeant ainsi ces portions lors de la mise en oeuvre d'étapes pouvant par exemple détériorer le matériau getter et/ou altérer les propriétés d'absorption et/ou d'adsorption gazeuse du matériau getter, par exemple dans le cas d'un nettoyage chimique par solution d'HF. Cette couche de protection 130 permet également d'empêcher temporairement le matériau getter 110 de réaliser un pompage gazeux (du fait que le matériau getter 110 est destiné à réaliser ce pompage gazeux qu'après avoir été disposé dans la cavité qui sera fermée hermétiquement).

La structure getter 400 peut être obtenue en formant tout d'abord la portion de matériau poreux 108, puis la portion de matériau getter 110, puis la couche de protection hermétique 130. Dans un mode de réalisation avantageux, la structure getter 400 sera obtenue en réalisant la portion de matériau poreux 108, la portion de matériau getter 110 et la couche de protection hermétique 130 par trois étapes de dépôt successives réalisées dans un même cycle de vide à travers trois pochoirs, ici de motifs différents.

La structure getter 400 est ensuite assemblée à un substrat 1002 sur lequel est réalisé un microcomposant 1004, par exemple de type MEMS et/ou NEMS, formant ainsi le dispositif 1000 (figure 5B). Le microcomposant 1004 se retrouve donc encapsulé dans une cavité 1006 formée entre le support 102 (formant le capot) et le substrat 1002. Les parois latérales de la cavité 1006 correspondent aux portions latérales 128 du support 102. L'assemblage des portions latérales 128 au substrat 1002 est réalisé par un scellement fermant hermétiquement la cavité 1006, obtenu par exemple par collage moléculaire ou toute autre technique de scellement adaptée telle qu'un scellement anodique ou eutectique.

Si la portion de matériau getter 110 et la couche de protection hermétique 130 n'ont pas été réalisées dans le même cycle de vide, le matériau getter peut être activé thermiquement lors de son encapsulation hermétique. Cette activation thermique permet de régénérer le potentiel de capacité de pompage du matériau getter. On régénère de préférence le potentiel de capacité de pompage du getter avant de réaliser une ouverture de la couche de protection hermétique. Ainsi, on obtient un matériau getter avec tout son potentiel actif encapsulé hermétiquement.

Cette encapsulation de protection permet d'une part de maintenir ce potentiel de capacité de pompage actif jusqu'à la mise en place du getter dans le produit et l'ouverture dans la protection d'un canal d'accès au matériau getter. D'autre part, l'encapsulation peut aussi jouer un rôle de protection contre les éventuelles agressions du process qu'il reste à réaliser jusqu'au produit final: par exemple lors d'un nettoyage chimique incompatible avec le matériau getter (par exemple avec une solution HF), ou lors d'un traitement thermique sous atmosphère pompable par le getter, par exemple à une température d'environ 400°C sous atmosphère de N₂.

La structure getter étant encapsulée hermétiquement, il est possible de réaliser un dégazage du capot à des températures telles qu'un getter non hermétiquement protégé s'activerait et réaliserait un pompage gazeux (dans l'enceinte de la chambre de dégazage ou lors de la remise à l'air). Du fait que le matériau getter soit encapsulé hermétiquement, le dégazage du capot et la remise à l'air ne dégradent pas la capacité de pompage potentielle du getter.

Les différentes étapes technologiques réalisées ensuite sur le dispositif 1000 n'ont donc pas d'impact sur le matériau getter 110 tant que celui-ci est protégé par la couche de protection hermétique 130.

De plus, les capacités de pompage du matériau getter 110 sont préservées tant que celui-ci est confiné hermétiquement entre la couche de protection 130 et le support 102.

Lorsque l'on souhaite « activer » la fonction d'absorption/adsorption gazeuse du matériau getter, on réalise une ouverture 132, par exemple localisée dans une partie de la couche de protection 130, à travers la couche de protection hermétique 130 afin de former un accès à la partie 111 de la portion 108 de matériau poreux (figure 5C). Cette ouverture 132 est par exemple réalisée par impact laser à travers le substrat 1002.

Si cet impact laser provoque des scories (déchets solides), il est possible de réaliser cette ouverture 132 dans une portion de la couche de la protection 130 éloignée du microcomposant 1004 afin de réduire ou supprimer la pollution de ces scories qui peuvent altérer le fonctionnement du microcomposant 1004.

Grâce à cette ouverture 132, le matériau getter 110 peut remplir sa fonction d'absorption et/ou d'adsorption gazeuse depuis sa face arrière 114 à travers la portion 108 de matériau poreux et l'ouverture 132. On peut ainsi réaliser par exemple un environnement sous pression réduite dans la cavité 1006, autour du microcomposant 1004.

Dans une variante de réalisation de la structure getter 400, la portion de matériau poreux 108 peut être remplacée par la portion de matériau 120 comportant les canaux 122 de la structure getter 200.

Dans ce cas, l'ouverture 132 réalisée à travers la couche de protection 130 formera un accès à au moins une partie des canaux 122. Dans une autre variante de réalisation, il est possible de former la portion de matériau getter 110 directement sur le support 102, au-dessus de canaux 122 réalisés directement dans le support 102. Là encore, l'ouverture 132 réalisée à travers la couche de protection 130 formera un accès à au moins une partie de ces canaux 122. De plus, comme pour les structures getter 100, 200 précédemment décrites, une ou plusieurs portions ou couches de matériau peuvent être disposées entre le support 102 et la portion de matériau poreux 108 ou entre le support 102 et la portion de matériau 120 comportant les canaux 122.

Dans une autre variante de réalisation, la couche de protection 130 peut être remplacée par la couche 302 composée de matériau fusible.

Dans une autre variante, il est possible qu'une partie de la couche de protection 130, au niveau d'une extrémité d'un ou plusieurs canaux 122, soit recouverte par une portion de matériau fusible. Lorsque la couche de protection 130 est assez fine et composée d'un matériau pouvant être dissous par le matériau fusible en fusion (correspondant par exemple au cas d'une couche de protection 130 composée de chrome et d'épaisseur comprise entre quelques nanomètres et quelques dizaines de nanomètres), la mise en fusion du matériau fusible dissout donc localement la couche de protection 130, formant ainsi un ou plusieurs accès aux parties d'un ou plusieurs canaux 122 se trouvant à l'aplomb de l'ouverture formée à travers la couche de protection 130.

Dans une autre variante de réalisation, une couche de matériau fusible peut être réalisée en périphérie de la portion de matériau getter 110, et pouvant recouvrir éventuellement une partie de la portion getter 110 (la couche de protection 130 est absente). En exposant le matériau fusible à une température suffisante, le matériau fusible se rassemble sous la forme d'une goutte métallique en bordure de la portion de matériau getter, réalisant ainsi un accès à l'extrémité des canaux 122. Le matériau getter reste donc activable au niveau de ses deux faces principales.

On se réfère à la figure 6 qui représente une structure getter 500 selon un cinquième mode de réalisation.

La structure getter 500 comporte ici un empilement de plusieurs portions de matériau getter (deux sur l'exemple de la figure 6) 110a et 110b disposées sur le support 102. Les portions de matériau getter 110a, 110b sont ici entièrement entourées par les portions de matériau poreux 108a, 108b. L'ensemble de cet empilement est protégé par la couche de protection hermétique 130 qui entoure complètement les portions de matériau poreux 108a, 108b. Dans ce cinquième mode de réalisation, toutes les faces des portions de matériau getter 110a, 110b sont en contact avec le matériau poreux des portions 108a, 108b. Ainsi, par l'intermédiaire de l'ouverture 132 réalisée à travers la couche de protection 130 et qui débouche sur la portion de matériau poreux 108b, les portions de matériau getter 110a, 110b peuvent réaliser une absorption et/ou une adsorption gazeuse depuis l'ensemble de leurs faces (faces avant, arrière et latérales) à travers les portions de matériau poreux 108a, 108b.

La structure getter 500 peut être obtenue en réalisant tout d'abord une première partie 130a de la couche de protection hermétique 130, par exemple par dépôt, cette partie formant une portion de couche plane disposée contre le support 102. Une première partie (également sous la forme d'une portion plane) de la première portion de matériau poreux 108a est ensuite formée sur la première partie 130a de la couche de protection hermétique 130. La première portion de matériau getter 110a est ensuite déposée sur la première partie de la première portion de matériau poreux 108a. Une seconde partie de la première portion de matériau poreux 108a est ensuite déposée sur la première portion de matériau getter 110a telle que la première portion de matériau getter 110a soit complètement entourée par la première portion de matériau poreux 108a. La deuxième portion de matériau getter 110b est ensuite déposée sur la première portion de matériau poreux 108a, en utilisant par exemple le même pochoir que celui utilisé pour le dépôt de la première portion de matériau getter 110a. La deuxième portion de matériau poreux 108b est ensuite déposée en recouvrant complètement la deuxième portion de matériau getter 110b. Enfin, on réalise le dépôt d'une seconde partie 130b de la couche de protection hermétique 130 telle que cette couche de protection hermétique 130 entoure et protège hermétiquement les portions de matériau getter 110a, 110b et les portions de matériau poreux 108a, 108b. L'ouverture 132 est enfin réalisée à travers la couche de protection hermétique 130. Toutes ces étapes seront avantageusement réalisées dans un même cycle de vide.

La superposition de plusieurs portions de matériau getter peut également s'appliquer aux structures getter 100, 200, 300 et 400 précédemment décrites. Il est notamment possible de superposer plusieurs portions de matériau getter et de combiner, afin de former des accès aux portions de matériau getter, une ou plusieurs portions de matériau poreux (similaires à la portion 108) avec une ou plusieurs portions de matériau comportant des canaux (similaires à la portion 120).

On décrit maintenant, en liaison avec les figures 7 et 8, un exemple de réalisation d'une structure getter 600 et d'un dispositif microélectronique 2000 comportant un microcomposant 1004 encapsulé.

Comme le dispositif 1000 précédemment décrit, le dispositif 2000 comporte le substrat 1002 sur lequel est réalisé le microcomposant 1004, par exemple de type MEMS et/ou NEMS (voir figure 7). Le microcomposant 1004 est encapsulé dans la cavité 1006.

Contrairement au dispositif 1000, la cavité 1006 est ici fermée par un capot 2002 de type PCM (Packaging Couche Mince). Le capot 2002 comporte une ouverture 2004 formant un accès à l'intérieure de la cavité 1006, cet accès servant notamment, lors de la réalisation du dispositif 2000, à retirer un matériau sacrificiel sur lequel la couche mince formant le capot 2002 a été déposée.

On réalise ensuite la structure getter 600 sur les éléments du dispositif 2000 précédemment réalisés. Une portion de matériau poreux 108 est tout d'abord réalisée (par exemple par un dépôt à travers un pochoir) sur le capot 2002, l'ouverture 2004 étant recouverte par une partie de la portion de matériau poreux 108. Une portion de matériau getter 110 est ensuite déposée sur la portion de matériau poreux 108, par exemple sous une même atmosphère et à travers un pochoir (de motif similaire sur l'exemple de la figure 8). Enfin, l'ensemble est recouvert par une couche de protection hermétique 130, par exemple obtenue par un dépôt sous vide (par exemple par évaporation ou pulvérisation) à travers un pochoir.

On obtient ainsi le dispositif 2000 représenté sur la figure 8, dans lequel la portion de matériau getter 110 réalise une absorption et/ou une adsorption du gaz présent dans la cavité 1006 par sa face arrière 114 qui est entièrement accessible via l'ouverture 2004 et à travers la portion de matériau poreux 108, permettant par exemple de réaliser un environnement sous pression réduite dans la cavité 1006, autour du microcomposant 1004.

Les portions 108 et 110 ainsi que la couche de protection 130 seront avantageusement déposées dans un même cycle de vide par des dépôts par évaporation ou à travers des pochoirs.

On se réfère maintenant aux figures 9A et 9B qui représentent les étapes de réalisation d'un dispositif 3000 comportant un microcomposant 1004 destiné à être encapsulé, avec une structure getter 700, dans une cavité 1006.

Le dispositif 3000 comporte le microcomposant 1004 réalisé sur un substrat 1002. La structure getter 700 est également réalisée sur le substrat 1002, à côté du microcomposant 1004. La structure getter 700 comporte la portion de matériau poreux 108 qui entoure complètement la portion de matériau getter 110. De plus, la couche de protection hermétique 130 entoure complètement la couche de matériau poreux 108.

La structure getter 700 est par exemple obtenue en réalisant tout d'abord un dépôt d'une première partie 130a de la couche de protection hermétique 130, cette première partie formant une portion de matériau (plane dans ce mode de réalisation) disposée contre le support 102. Une première partie (également sous la forme d'une portion plane dans cet exemple de réalisation) de la portion de matériau poreux 108 est ensuite formée sur la première partie 130a de la couche de protection hermétique 130. La portion de matériau getter 110 est ensuite déposée sur la première partie de la portion de matériau poreux 108. Une seconde partie de la portion de matériau poreux 108 est ensuite déposée sur la portion de matériau getter 110 qui se retrouve tout ou partie entourée par la portion de matériau poreux 108. Enfin, on réalise le dépôt d'une seconde partie 130b de la couche de protection hermétique 130 telle que cette couche de protection hermétique entoure et protège hermétiquement la portion de matériau getter 110 et la portion de matériau poreux 108. Toutes ces étapes seront avantageusement réalisées dans un même cycle de vide ou sous une même atmosphère.

Comme représenté sur la figure 9B, on réalise ensuite un scellement hermétique d'un capot 3002 sur le substrat 1002 afin d'encapsuler la structure getter 700 et le microcomposant 1004 dans une même cavité 1006.

Lorsque l'on souhaite « activer » la fonction d'absorption et/ou d'adsorption gazeuse du matériau getter 110, on réalise alors une ouverture 132 à travers la couche de protection hermétique 130, par exemple par impact laser à travers le capot 3002 par exemple composé de verre ou de silicium, de manière analogue à l'exemple précédemment décrit en liaison avec la figure 5C. L'ouverture 132 débouche sur la surface de la portion de matériau poreux 108.

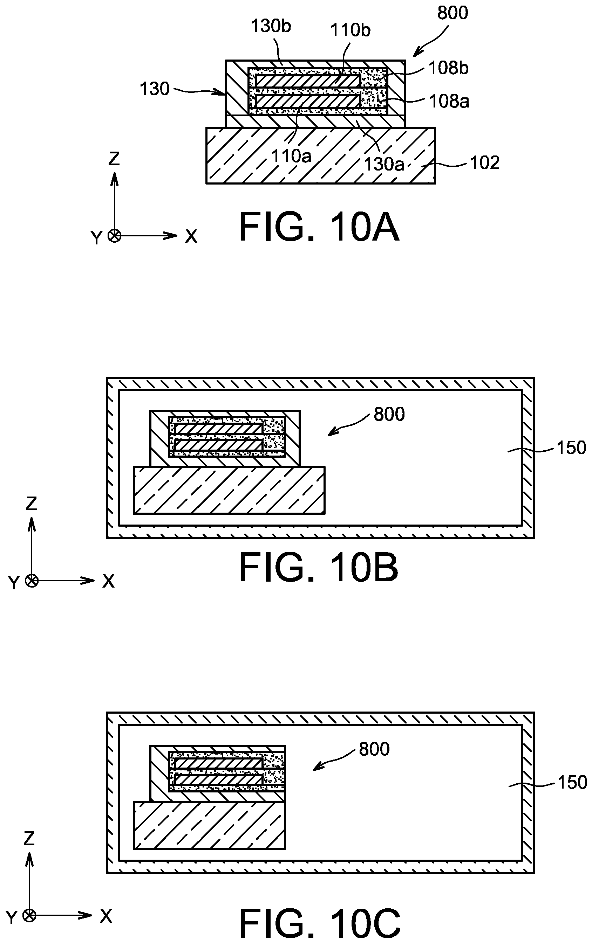

On se réfère maintenant aux figures 10A à 10C pour décrire une structure getter 800 selon un sixième mode de réalisation.

Comme représenté sur la figure 10A, la structure getter 800 comporte les mêmes éléments que la structure getter 500, excepté que seule une portion du support 102 est conservée. On obtient ainsi une structure getter 800 pouvant être utilisée de manière autonome, et pouvant par exemple être disposée dans une cavité 150 d'un dispositif, par exemple dans un tube écran (voir figure 10B).

Afin d'activer la fonction de pompage gazeux de la structure getter 800, on crée une ouverture de la structure getter 800 afin de mettre à nu une partie des portions de matériau poreux 108a, 108b de la structure getter 800. Cette ouverture est par exemple obtenue en cassant, par exemple par un choc de la structure 800 contre une paroi de la cavité 150 ou par un tir laser, une partie de la structure getter 800. Il est possible de favoriser l'ouverture de la structure getter 800 en réalisant au préalable une amorce mécanique au sein de la structure getter 800.

Cette ouverture peut être réalisée en conservant intactes les portions de matériau getter 110a, 110b.

Dans les modes de réalisation utilisant une couche de protection, le matériau getter est généralement rendu actif après son dépôt (lorsque les différents dépôts n'ont pas été réalisés au cours du même cycle de vide) et par exemple après son encapsulation dans la couche de protection 130, par une étape d'activation thermique. Par exemple, dans le cas d'un matériau getter composé de titane, une telle activation thermique peut être réalisée à une température par exemple comprise entre environ 350°C et 450°C.

Dans tous les modes de réalisation précédemment décrits, la ou les portions de matériau getter sont planes du fait que les différents supports sur lesquels la ou les portions de matériau getter sont réalisées présentent une surface sensiblement plane.

Toutefois, il est possible que la surface du matériau perméable aux gaz sur laquelle est disposée la portion de matériau getter ne soit pas plane et présente des reliefs, par exemple des saillies, ce qui permet d'augmenter encore la surface d'absorption et/ou d'adsorption gazeuse de la portion de matériau getter.

Dans tous les modes de réalisation précédemment décrits, la portion de matériau perméable aux gaz peut être composée de matériau getter. Un matériau getter poreux peut être obtenu par un dépôt réalisé à une température de dépôt Ts telle que le rapport Ts/Tm soit inférieur à environ 0,3, Tm étant la température de fusion du matériau getter, les températures Ts et Tm étant exprimées en Kelvin.

Lorsque le matériau getter poreux est déposé par évaporation dans ces conditions de dépôt, le matériau getter poreux obtenu présente alors une structure colonnaire comprenant des cônes inversés (partie la plus large du cône en haut), en forme de dômes dans la partie supérieure, ces cônes étant séparés par des espaces vides. L'ouvrage « Materials Science of Thin Films », Second Edition, Milton Ohring, Academic Press, chapitre 9.2.1.2 SZM for Evaporated Films, page 498, décrit des détails de réalisation d'un tel matériau poreux. La perméabilité aux gaz de la portion de matériau getter peut également être obtenue en structurant la portion de matériau getter 110 afin de former à travers celle-ci des canaux, ou micro-canaux, comme décrit en liaison avec la figure 3.

Dans tous les modes de réalisation et variantes précédemment décrites, il est possible que la perméabilité de la portion de matériau contre laquelle est disposée la portion de matériau soit obtenue via un ou plusieurs canaux formés dans cette portion de matériau.

## Revendications

1. Structure getter (100 - 800) comportant au moins une portion de matériau getter (110) et une portion de matériau (108, 120) perméable aux gaz telle qu'au moins une face (114) de la portion de matériau getter (110) soit disposée contre la portion de matériau (108, 120) perméable aux gaz telle que ladite portion de matériau getter (110) soit apte à réaliser une absorption et/ou une adsorption gazeuse au moins par ladite face (114) à travers au moins ladite portion de matériau (108, 120) perméable aux gaz,
dans laquelle la portion de matériau (108, 120) perméable aux gaz comporte un ou plusieurs canaux (122) réalisés au niveau d'une face (124) de ladite portion de matériau (108, 120) perméable aux gaz qui est en contact avec la portion de matériau getter (110),
la portion de matériau getter (110) étant apte à réaliser une absorption et/ou une adsorption gazeuse via le ou les canaux (122),
- la portion de matériau (108, 120) perméable aux gaz étant disposée entre la portion de matériau getter (110) et un support (102, 1002, 2002), **caractérisée en ce que** :
- la structure getter (100 - 800) comporte en outre au moins une couche de protection (130) hermétique aux gaz recouvrant un empilement comprenant au moins la portion de matériau (108) perméable aux gaz et la portion de matériau getter (110), et au moins une ouverture (132) formée à travers la couche de protection (130) hermétique aux gaz et débouchant sur l'empilement,
- les dimensions de la portion de matériau (108, 120) perméable aux gaz, dans un plan de ladite face (124) de la portion de matériau (108, 120) perméable aux gaz, sont supérieures à celles de la portion de matériau getter (110) tel qu'une partie (111) de la portion de matériau (108, 120) perméable aux gaz n'est pas recouverte par la portion de matériau getter (110) et que l'ouverture (132) forme un accès à la partie (111) de la portion de matériau (108, 120) perméable aux gaz non recouverte par la portion de matériau getter (110).

2. Structure getter (100 - 800) selon la revendication 1, dans laquelle la portion de matériau (108, 120) perméable aux gaz est composée d'au moins un matériau poreux.

3. Structure getter (500, 700, 800) selon l'une des revendications précédentes, dans laquelle la portion de matériau (108) perméable aux gaz entoure tout ou partie de la portion de matériau getter (110).

4. Structure getter (500, 800) selon l'une des revendications précédentes, comportant un empilement de plusieurs portions de matériau getter (110a, 110b) et de plusieurs portions de matériau (108a, 108b) perméable au gaz, au moins une face de chacune des portions de matériau getter (110a, 110b) étant disposée contre au moins une des portions de matériau (108a, 108b) perméable aux gaz telle que chacune des portions de matériau getter (110a, 110b) soit apte à réaliser une absorption et/ou une adsorption gazeuse par ladite face à travers au moins ladite une des portions de matériau (108a, 108b) perméable aux gaz.

5. Structure getter (500, 800) selon la revendication 4, dans laquelle la couche de protection (130) hermétique aux gaz recouvre l'empilement de portions de matériau getter (110a, 110b) et de portions de matériau (108a, 108b) perméable au gaz.

6. Dispositif (1000, 3000) comportant au moins un microcomposant (1004) encapsulé dans une cavité (1006), et dans lequel au moins une structure getter (400, 700) selon l'une des revendications précédentes est disposée dans la cavité (1006).

7. Dispositif (1000, 3000) selon la revendication 6, dans lequel la cavité (1006) est formée entre un substrat (1002) et un capot (102, 3002).

8. Dispositif (1000, 3000) selon la revendication 7, dans lequel la structure getter (400, 700) est solidaire du substrat (1002) ou du capot (102) .

9. Dispositif (2000) comportant au moins un microcomposant (1004) encapsulé dans une cavité (1006), au moins une ouverture (2004) étant formée à travers au moins une paroi de la cavité (1006) et recouverte par une partie d'une portion de matériau (108) perméable aux gaz d'une structure getter (600) selon l'une des revendications 1 à 5.

10. Procédé de réalisation d'une structure getter (100 - 800) comportant au moins les étapes de :
- réalisation, sur un support (102, 1002, 2002), d'au moins une portion de matériau (108, 120) perméable aux gaz ;
- réalisation d'un ou plusieurs canaux (122) au niveau d'une face (104, 124) de ladite portion de matériau (108, 120) perméable aux gaz qui est destinée à être en contact avec au moins une portion de matériau getter (110) ;
- réalisation de la portion de matériau getter (110) dont au moins une face (114) est disposée contre la portion de matériau (108, 120) perméable aux gaz telle que ladite portion de matériau getter (110) soit apte à réaliser une absorption et/ou une adsorption gazeuse par ladite face (114) à travers au moins ladite portion de matériau (108, 120) perméable aux gaz via le ou les canaux (122), la portion de matériau (108, 120) perméable aux gaz étant disposée entre la portion de matériau getter (110) et le support (102, 1002, 2002), et telle que les dimensions de la portion de matériau (108, 120) perméable aux gaz, dans un plan de ladite face (124) de la portion de matériau (108, 120) perméable aux gaz, soient supérieures à celle s de la portion de matériau getter (110) tel qu'une partie (111) de la portion de matériau (108, 120) perméable aux gaz n'est pas recouverte par la portion de matériau getter (110);
- réalisation d'une couche de protection (130) hermétique aux gaz recouvrant un empilement comprenant au moins la portion de matériau (108) perméable aux gaz et la portion de matériau getter (110), et d'au moins une ouverture (132) formée à travers la couche de protection (130) hermétique aux gaz et débouchant sur l'empilement telle que l'ouverture (132) forme un accès à la partie (111) de la portion de matériau (108, 120) perméable aux gaz non recouverte par la portion de matériau getter (110).

## Patentansprüche

1. Getterstruktur (100 - 800), enthaltend zumindest einen Gettermaterialabschnitt (110) und einen gasdurchlässigen Materialabschnitt (108, 120), derart, dass zumindest eine Fläche (114) des Gettermaterialabschnitts (110) an dem gasdurchlässigen Materialabschnitt (108, 120) angeordnet ist, so dass der Gettermaterialabschnitt (110) dazu geeignet ist, eine Gasabsorption und/oder -Adsorption zumindest über die Fläche (114) zumindest durch den gasdurchlässigen Materialabschnitt (108, 120) hindurch durchzuführen,
wobei der gasdurchlässige Materialabschnitt (108, 120) einen oder mehrere Kanäle (122) aufweist, die im Bereich einer Fläche (124) des gasdurchlässigen Materialabschnitts (108, 120), die mit dem Gettermaterialabschnitt (110) in Kontakt steht, ausgebildet sind,
wobei der Gettermaterialabschnitt (110) dazu geeignet ist, eine Gasabsorption und/oder -Adsorption über den bzw. die Kanäle (122) durchzuführen,
- wobei der gasdurchlässige Materialabschnitt (108, 120) zwischen dem Gettermaterialabschnitt (110) und einem Träger (102, 1002, 2002) angeordnet ist,
**dadurch gekennzeichnet, dass**
- die Getterstruktur (100 - 800) ferner zumindest eine gasdichte Schutzschicht (130) aufweist, die eine zumindest den gasdurchlässigen Materialabschnitt (108) und den Gettermaterialabschnitt (110) aufweisende Stapelung überdeckt, sowie zumindest eine Öffnung (132), die durch die gasdichte Schutzschicht (130) hindurch ausgeführt ist und in die Stapelung mündet,
- die Abmessungen des gasdurchlässigen Materialabschnitts (108, 120) in einer Ebene der Fläche (124) des gasdurchlässigen Materialabschnitts (108, 120) größer als die des Gettermaterialabschnitts (110) sind, so dass ein Teil (111) des gasdurchlässigen Materialabschnitts (108, 120) nicht mit dem Gettermaterialabschnitt (110) überdeckt ist und dass die Öffnung (132) einen Zugang zum nicht von dem Gettermaterialabschnitt (110) überdeckten Teil (111) des gasdurchlässigen Materialabschnitts (108, 120) bildet.

2. Getterstruktur (100 - 800) nach Anspruch 1, wobei der gasdurchlässige Materialabschnitt (108, 120) aus zumindest einem porösen Material zusammengesetzt ist.

3. Getterstruktur (500, 700, 800) nach einem der vorangehenden Ansprüche, wobei der gasdurchlässige Materialabschnitt (108) den Gettermaterialabschnitt (110) ganz oder teilweise umgibt.

4. Getterstruktur (500, 800) nach einem der vorangehenden Ansprüche, enthaltend eine Stapelung von mehreren Gettermaterialabschnitten (110a, 110b) und mehreren gasdurchlässigen Materialabschnitten (108a, 108b), wobei zumindest eine Fläche eines jeden der Gettermaterialabschnitte (110a, 110b) an zumindest einem der gasdurchlässigen Materialabschnitte (108a, 108b) angeordnet ist, so dass jeder der Gettermaterialabschnitte (110a, 110b) dazu geeignet ist, eine Gasabsorption und/oder -Adsorption über die Fläche durch zumindest einen der gasdurchlässigen Materialabschnitte (108a, 108b) hindurch durchzuführen.

5. Getterstruktur (500, 800) nach Anspruch 4, wobei die gasdichte Schutzschicht (130) die Stapelung aus Gettermaterialabschnitten (110a, 110b) und gasdurchlässigen Materialabschnitten (108a, 108b) überdeckt.

6. Vorrichtung (1000, 3000), enthaltend zumindest eine Mikrokomponente (1004), die in einem Hohlraum (1006) eingekapselt ist, wobei zumindest eine Getterstruktur (400, 700) nach einem der vorangehenden Ansprüche in dem Hohlraum (1006) angeordnet ist.

7. Vorrichtung (1000, 3000) nach Anspruch 6, wobei der Hohlraum (1006) zwischen einem Substrat (1002) und einer Kappe (102, 3002) ausgebildet ist.

8. Vorrichtung (1000, 3000) nach Anspruch 7, wobei die Getterstruktur (400, 700) fest mit dem Substrat (1002) bzw. der Kappe (102) verbunden ist.

9. Vorrichtung (2000), enthaltend zumindest eine Mikrokomponente (1004), die in einem Hohlraum (1006) eingekapselt ist, wobei zumindest eine Öffnung (2004) durch zumindest eine Wand des Hohlraums (1006) hindurch ausgebildet ist und mit einem Teil eines gasdurchlässigen Materialabschnitts (108) einer Getterstruktur (600) nach einem der Ansprüche 1 bis 5 überdeckt ist.

10. Verfahren zum Herstellen einer Getterstruktur (100 - 800), das zumindest nachfolgende Schritte umfasst:
- Ausbilden zumindest eines gasdurchlässigen Materialabschnitts (108, 120) auf einem Träger (102, 1002, 2002);
- Ausbilden eines oder mehrerer Kanäle (122) im Bereich einer Fläche (104, 124) des gasdurchlässigen Materialabschnitts (108, 120), die dazu bestimmt ist, mit zumindest einem Gettermaterialabschnitt (110) in Kontakt zu stehen;
- Ausbilden des Gettermaterialabschnitts (110), von dem zumindest eine Fläche (114) an dem gasdurchlässigen Materialabschnitt (108, 120) angeordnet ist, so dass der Gettermaterialabschnitt (110) dazu geeignet ist, eine Gasabsorption und/oder -Adsorption über die Fläche (114) zumindest durch den gasdurchlässigen Materialabschnitt (108, 120) hindurch über den bzw. die Kanäle (122) durchzuführen, wobei der gasdurchlässige Materialabschnitt (108, 120) zwischen dem Gettermaterialabschnitt (110) und dem Träger (102, 1002, 2002) angeordnet ist, und derart, dass die Abmessungen des gasdurchlässigen Materialabschnitts (108, 120) in einer Ebene der Fläche (124) des gasdurchlässigen Materialabschnitts (108, 120) größer als die des Gettermaterialabschnitts (110) sind, so dass ein Teil (111) des gasdurchlässigen Materialabschnitts (108, 120) nicht mit dem Gettermaterialabschnitt (110) überdeckt ist;
- Ausbilden einer gasdichten Schutzschicht (130), die eine zumindest den gasdurchlässigen Materialabschnitt (108) und den Gettermaterialabschnitt (110) aufweisenden Stapelung überdeckt, sowie zumindest einer Öffnung (132), die durch die gasdichte Schutzschicht (130) hindurch ausgeführt ist und in die Stapelung mündet, derart, dass die Öffnung (132) einen Zugang zum nicht von dem Gettermaterialabschnitt (110) überdeckten Teil (111) des gasdurchlässigen Materialabschnitts (108, 120) bildet.

## Claims

1. A getter structure (100 - 800) including at least one portion of getter material (110) and a portion of gas-permeable material (108, 120) such that at least one face (114) of the portion of getter material (110) is arranged against the portion of gas-permeable material (108, 120) such that said portion of getter material (110) is able to achieve a gaseous absorption and/or adsorption at least by said face (114) through at least said portion of gas-permeable material (108, 120),
In which the portion of gas-permeable material (108, 120) includes one or more channels (122) made at a face (124) of said portion of gas-permeable material (108, 120) which is in contact with the portion of getter material (110),
The portion of getter material (110) being able to achieve a gaseous absorption and/or a gaseous adsorption via the channel or channels (122),
- The portion of gas-permeable material (108, 120) being arranged between the portion of getter material (110) and a support (102, 1002, 2002), **Characterized in that**:
- the getter structure (100 - 800) includes at least one protective layer (130) which is hermetic to the gases, covering a stack including at least the portion of gas-permeable material (108) and the portion of getter material (110), and at least one opening (132) formed through the protective layer (130) hermetic to the gases and emerging onto the stack,
- the dimensions of the portion of gas-permeable material (108, 120), in a plane of said face (124) of the portion of gas-permeable material (108, 120), are greater than those of the portion of getter material (110) such that a part (111) of the portion of gas-permeable material (108, 120) is not covered by the portion of getter material (110) and that the opening (132) forms an access to the part (111) of the portion of gas-permeable material (108, 120) not covered by the portion of getter material (110).

2. The getter structure (100 - 800) according to claim 1, in which the portion of gas-permeable material (108, 120) comprises at least one porous material.

3. The getter structure (500, 700, and 800) according to one of previous claims, in which the portion of gas-permeable material (108) surrounds all or part of the portion of getter material (110).

4. The getter structure (500, 800) according to one of previous claims, including a stack of several portions of getter material (110a, 110b) and of several portions of gas-permeable material (108a, 108b), at least one face of each of the portions of getter material (110a, 110b) being arranged against at least one of the portions of gas-permeable material (108a, 108b) such that each of the portions of getter material (110a, 110b) is able to achieve a gaseous absorption and/or adsorption by said face through at least said one of the portions of gas-permeable material (108a, 108b).

5. The getter structure (500, 800) according to claim 4, in which the protective layer (130) which is hermetic to the gases covers the stack of portions of getter material (110a, 110b) and of portions of gas-permeable material (108a, 108b).

6. A device (1000, 3000) including at least one microcomponent (1004) encapsulated in a cavity (1006), and in which at least one getter structure (400, 700) according to one of previous claims is arranged in the cavity (1006).

7. The device (1000, 3000) according to claim 6, in which the cavity (1006) is formed between a substrate (1002) and a cover (102, 3002).

8. The device (1000, 3000) according to claim 7, in which the getter structure (400, 700) is attached to the substrate (1002) or to the cover (102).

9. A device (2000) including at least one microcomponent (1004) encapsulated in a cavity (1006), at least one opening (2004) being formed through at least one wall of the cavity (1006) and covered by a part of a portion of gas-permeable material (108) of a getter structure (600) according to one of claims 1 to 5.

10. A method for producing a getter structure (100 - 800), including at least the following steps:
- production, on a support (102, 1002, 2002), of at least one portion of gas-permeable material (108, 120);
- production of one or more channels (122) at a face (104, 124) of said portion of gas-permeable material (108, 120) which is intended to be in contact with at least one portion of getter material (110);
- production of the portion of getter material (110) at least one face (114) of which is arranged against the portion of gas-permeable material (108, 120) such that said portion of getter material (110) is able to achieve a gaseous absorption and/or adsorption by said face (114) through at least said portion of gas-permeable material (108, 120) via the channel or channels (122), the portion of gas-permeable material (108, 120) being arranged between the portion of getter material (110) and the support (102, 1002, 2002), and such that the dimensions of the portion of gas-permeable material (108, 120), in a plane of said face (124) of the portion of gas-permeable material (108, 120), are greater than those of the portion of getter material (110) such that a part (111) of the portion of gas-permeable material (108, 120) is not covered by the portion of getter material (110);
- production of a protective layer (130) which is hermetic to the gases, covering a stack including at least the portion of gas-permeable material (108) and the portion of getter material (110), and of at least one opening (132) formed through the protective layer (130) hermetic to the gases and emerging onto the stack such that the opening (132) forms an access to the part (111) of the portion of gas-permeable material (108, 120) not covered by the portion of getter material (110).
